# EUROPÄISCHE PATENTSCHRIFT

(11) **EP 0 371 380 B1**
(45) Veröffentlichungstag und Bekanntmachung des Hinweises auf die Patenterteilung: **16.03.1994**
(21) Anmeldenummer: 89121535.2
(22) Anmeldetag: 21.11.1989
(51) Int. Cl.: H01L 31/105, H01L 27/144

(54) **Fotodiode-FET-Kombination mit optimierter Schichtstruktur**
Photodiode-FET combination with an enhanced layer structure
Combinaison photodiode-FET à structure de couches optimisée

(30) Priorität: 29.11.1988 DE 3840227
(43) Veröffentlichungstag der Anmeldung: 06.06.1990
(73) Patentinhaber: SIEMENS AKTIENGESELLSCHAFT, 80333 München (DE)
(72) Erfinder: Lauterbach, Christl, D-8011 Siegertsbrunn (DE); Albrecht, Helmut, Dr. Ing., D-8000 München 70 (DE)

(56) Entgegenhaltungen:
- EP-A- 0 073 889
- WO-A-86/04735
- PATENT ABSTRACTS OF JAPAN vol. 11, no. 17 (E-471)(2464) 17 Januar 1987, & JP-A-61 187363
- PATENT ABSTRACTS OF JAPAN vol. 12, no. 420 (E-679)(3267) 08 November 1988, & JP-A-63 156355
- SIEMENS FORSCHUNGS- UND ENTWICKLUNGSBERICHTE, vol. 17, no. 4, 1988, BERLIN, DE, Seiten 195-198; H. ALBRECHT ET AL.: "MONOLITHICALLY INTEGRATED InGaAs/InP:Fe PHOTODIODE-JUNCTION-FIELD-EFFECT TRANSISTOR COMBINATION"

## Beschreibung

Die vorliegende Erfindung betrifft eine Fotodiode-Feldeffektransistor-Kombination mit optimierter Schichtstruktur die im Halbleitersystem InPInGaAs bzw. InAlAs/InGaAs integriert ist. Die Entwicklung optischer Datenübertragungssysteme geht dahin, für die Verbindung zwischen optischen und elektronischen Komponenten integrierte optoelektronische Schaltkreise einzusetzen. Auf der Empfängerseite stellt sich das Problem der Integration von Fotodetektor und Vorverstärker. Gefordert werden gute Kompatibilität der für die verschiedenen Komponenten benötigten Halbleiterschichten und Herstellungstechniken. Ein monolithisch integrierter planarer Baustein, der auf einem Halbleitersubstrat eine Fotodiode und einen Feldeffekttransistor (FET) enthält und der die unterschiedlichen Anforderungen an Dotierungskonzentration und Schichtdicke berücksichtigt ist, z.B. in der Veröffentlichung von H. Albrecht und Ch. Lauterbach: "Monolithically Integrated InGaAs/InP:Fe Photodiode-Junction Field-Effect Transistor Combination", Siemens Forschungs- und Entwicklungsberichte 17, 195 bis 198 (1988) angegeben.

Eine optimierte Fotodiode benötigt für einen hohen externen Quantenwirkungsgrad eine ausreichend dicke Absorptionsschicht aus n-InGaAs mit geringer Restdotierung. Diese nominell undotierte InGaAs-Schicht ist Voraussetzung für eine niedrige Kapazität sowie niedrigen Dunkelstrom und demzufolge gute Rauscheigenschaften. Eine hochdotierte n-leitende Halbleiterschicht (z.B. InGaAs oder InP oder InAlAs) auf dem InP:Fe-Substrat reduziert den Serienwiderstand und die Laufzeiteffekte, d.h. die Trägertransitzeit in der Diode.

Der FET benötigt für eine hohe Steilheit eine hochdotierte n⁺-InGaAs-Schicht, die für ein gutes Abschnürverhalten der FETs entsprechend dünn sein muß. Eine niedrig dotierte n⁻-InGaAs-Schicht zum Interface hin wirkt als Pufferschicht und verhindert störende Einflüsse vom Substrat (Ausdiffusion von Eisen in die Kanalschicht). Die Deckschicht aus n-InP bzw. n-InAlAs bildet zum InGaAs eine Heterobarriere und ermöglicht die Realisierung eines sperrenden Metallhalbleiterüberganges als Gate. Diese Schicht hat außerdem den Vorteil, daß aufgrund des höheren Bandabstandes von InP bzw. InAlAs im Vergleich zu InGaAs einer Passivierung des pn-Überganges an der Bauelementeoberfläche die Langzeitstabilität erhöht und Leckströme verringert. Dieser Vorteil gilt sowohl für die Fotodiode als auch für den Feldeffekttransistor. Ein solcher Aufbau eines Feldeffekttransistors ist angegeben in der Veröffentlichung von H. Albrecht und Ch. Lauterbach: "Normally-off InGaAs Junction Field Effect Transistor with InGaAs Buffer Layer", IEEE Electron Device Letter EDL-8, 353 bis 354 (1987). Auf einem semiisolierenden Indiumphosphid-Substrat sind eine schwach n-leitend dotierte InGaAs-Schicht und eine stark n-leitend dotierte InGaAs-Schicht mit einem darin eingebetteten, das Gate darstellenden stark p-leitend dotiertem InGaAs-Bereich aufgewachsen und kontaktiert.

Eine monolithische Integration dieses FET mit einer Fotodiode ist in der zuvor zitierten Veröffentlichung Siemens Forschungs-und Entwicklungsberichte angegeben. Bei der Fotodiode ist ein oberer Bereich der InGaAs-Bereiche stark p-leitend dotiert und liefert so den erforderlichen pn-Übergang.

Eine Deckschicht aus n-InP bzw. n-InAlAs bildet zum InGaAs eine Heterobarriere und ermöglicht die Realisierung eines sperrenden Metallhalbleiterüberganges für Fotodiode und Feldeffekttransistor als Gate. Alternativ wird durch selektive p-Diffusion bzw. p-Implantation ein pn-Übergang erzeugt. Diese Deckschicht hat außerdem den Vorteil, daß aufgrund des höheren Bandabstandes von InP bzw. InAlAs im Vergleich zu InGaAs eine Passivierung des pn-Überganges an der Bauelementeoberfläche die Langzeitstabilität erhöht und Leckströme verringert. Dieser Vorteil gilt sowohl für die Fotodiode als auch für den Feldeffekttransistor.

In dem Patent Abstract of Japan Vol. 11, Nr. 17 (E-471) (2464) vom 17.01.1987 zu der japanischen Patentanmeldung JP-A-61-187 363 ist ein integriertes optoelektronisches Bauelement beschrieben, bei dem eine Fotodiode und ein Feldeffekttransistor integriert sind. In einem semiisolierenden GaAs-Substrat ist ein p⁺-Bereich für eine PIN-Diode ausgebildet. Auf das Substrat ist ganzflächig eine p⁻-dotierte GaAs-Schicht aufgewachsen. Darauf befinden sich eine n-AlGaAs-Schicht und darauf eine n-GaAs-Schicht, die jeweils separat für den Feldeffekttransistor und die Fotodiode strukturiert sind. Diese Schichten sind mit Kontakten für die Fotodiode und den Feldeffekttransistor versehen.

Aufgabe der vorliegenden Erfindung ist es, eine Fotodiode-FET-Kombination mit einer optimierten Schichtstruktur, die möglichst einfach herstellbar ist, anzugeben.

Diese Aufgabe wird mit der Fotodiode-FET-Kombination mit den Merkmalen des Anspruches 1 gelöst. Weitere Ausgestaltungen ergeben sich aus den Unteransprüchen.

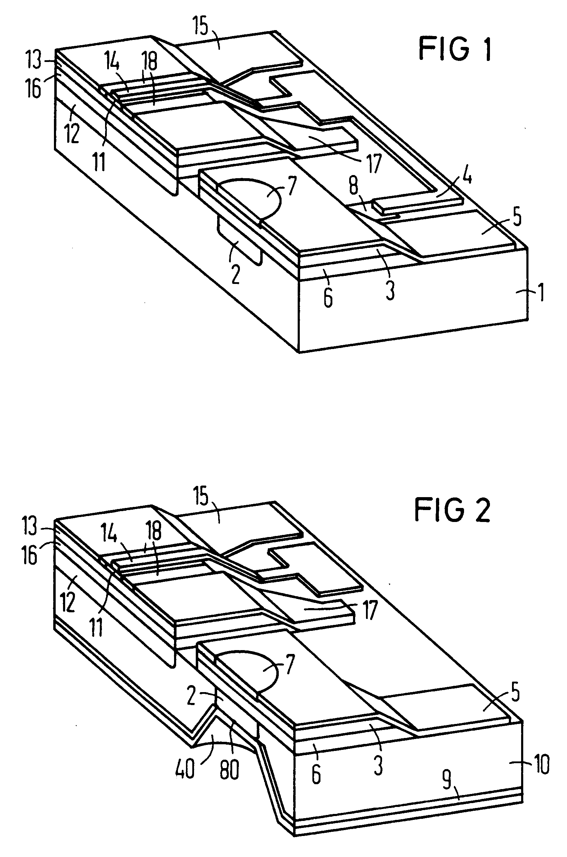

Es folgt eine Beschreibung einer erfindungsgemäßen Fotodiode-FET-Kombination anhand der Fig. 1 und 2.
- Fig. 1: zeigt ein erfindungsgemäßes Bauelement mit monolithisch integrierter Fotodiode und Feldeffekttransistor in einer ersten Ausführungsform.
- Fig. 2: zeigt ein erfindungsgemäßes Bauelement mit einer monolithisch integrierten Fotodiode und einem FET in einer weiteren Ausführungsform.

Auf einem z.B. mit Fe semiisolierend gemachten InP Substrat 1, 10 sind ein p⁺-Bereich 2 der Fotodiode und ein p⁺-Bereich 12 des FET durch p⁺-Implantation oder p⁺-Diffusion vor der Epitaxie ausgebildet. Der p⁺-Bereich 2 der Fotodiode stellt mit der darauf aufgewachsenen n-leitend dotierten Schicht den pn-Übergang dar, während der p⁺-Bereich 12 des FET das sogenannte back-gating, d.h. eine Beeinflussung des Kanals durch die Raumladungszone vom semiisolierenden Substrat her, reduziert. Epitaktisch ist auf das Substrat eine Schicht aus schwach n-leitend dotiertem InGaAs aufgewachsen, die so strukturiert ist, daß sie in einen n⁻-Bereich 6 der Fotodiode und einen n⁻-Bereich 16 des FET aufgeteilt ist. Darauf folgt als nächste epitaktische Schicht eine stark n-leitend dotierte InGaAs-Schicht, die entsprechend der darunter befindlichen Schicht strukturiert und in einen n⁺-Bereich 3 der Fotodiode und einen n⁺-Bereich 13 des FET aufgeteilt ist. Auf diesem n⁺-Bereich 13 befindet sich beim FET das Gate 11 aus stark p-leitend dotiertem InGaAs, das durch seitenbereiche 18 aus n-leitend dotiertem InP von dem Drain-Kontakt 15 und dem Source-Kontakt 17 isoliert ist und mit dem Gate-Kontakt 14 versehen ist. Der n⁺-Bereich 3 der Fotodiode ist mit einem ringförmig gestalteten n-Kontakt 5 versehen. Der von diesem ringförmigen n-Kontakt 5 umschlossene Bereich des n⁺-Bereiches 3 ist mit einer Deckschicht 7 aus n-leitend dotiertem InP planarisiert.

Die Kontaktierung des p⁺-Bereiches 2 der Fotodiode erfolgt in dem in Fig. 1 dargestellten Ausführungsbeispiel, in dem der p⁺-Bereich 2 auf der Oberseite des Substrates eine nicht überwachsene Kontaktfläche 8 aufweist, indem ein auf dieser Kontaktfläche 8 aufgebrachter p-Kontakt 4 leitend mit der Bond-Fläche des Gatekontaktes 14 verbunden ist. Bei der alternativen Ausgestaltung nach Fig. 2 erfolgt diese Kontaktierung des p⁺-Bereiches 2 der Fotodiode auf der Unterseite des Substrates 10, indem das Substrat 10 so weit ausgeätzt ist, daß die der überwachsenen Seite des Substrates 10 gegenüberliegende Oberfläche des p⁺-Bereiches 2 der Fotodiode eine freiliegende Kontaktfläche 80 aufweist, so daß die Unterseite des Substrates 10 ganzflächig mit dem p-Kontakt 40 der Fotodiode versehen werden kann. Außerhalb der Kontaktfläche 80 des p⁺-Bereiches der Fotodiode wird zwischen dem p-Kontakt 40 und dem Substrat 10 eine Isolationsschicht 9 aus z.B. SiNₓ aufgebracht.

Der erfindungsgemäße Aufbau der Fotodiode bringt im Vergleich zu der bekannten Struktur folgende Vorteile:
1. Bei monolithischer Integration mit einem Feldeffekttransistor beeinflußt die für den FET nötige n⁺-InGaAs-Schicht die Raumladungszone der Fotodiode nicht, sondern ersetzt die im Stand der Technik nötige n⁺-Implantation im InP:Fe-Substrat.
2. Der pn-Übergang der Fotodiode liegt, abgesehen von der Kontaktfläche 8, 80 des p⁺-Bereiches 2 der Fotodiode, völlig in der Epitaxiestruktur eingebettet; es sind daher keine Leckströme durch einen offenliegenden pn-Übergang zu erwarten. Eine Passivierung wie im Stand der Technik ist nicht erforderlich.
3. Bei dem erfindungsgemäßen Aufbau ist auf der Oberseite der Schichtstruktur der Fotodiode kein p-Kontakt, der ähnlich dem Gate-Kontakt zu dem Bondpad heruntergeführt werden müßte, erforderlich. Eine Verlängerung des Gate-Bondpads auf die Kontaktfläche 8 in der ersten Ausführungsform kann als p-Kontakt 4 verwendet werden, und die Metallbrücke der Fotodiode kann somit entfallen.
4. Wird als Gate des FETs ein sperrender Metall-Halbleiter-Übergang auf InP bzw. InAlAs verwendet und nicht ein pn-Übergang, so entfällt ein zusätzlicher p-Diffusions- bzw. p-Implantationsschritt.
5. Die Ausführungsform nach Fig. 2 hat den Vorteil, daß der Kontaktwiderstand des p-Kontaktes und die Zuleitungswiderstände zum p⁺-Bereich 2 der Fotodiode verkleinert werden.

## Patentansprüche

1. Fotodiode-FET-Kombination auf einem Substrat (1; 10) aus semiisolierendem InP,
bei der ein p⁺-dotierter Bereich (2) der Fotodiode und ein p⁺-dotierter Bereich (12) des FET in diesem Substrat (1; 10) ausgebildet sind,
bei der auf das Substrat (1; 10) eine Schicht aus n⁻-dotiertem InGaAs aufgewachsen ist, die so strukturiert ist, daß sie in einen n⁻-Bereich (6) der Fotodiode und einen n⁻-Bereich (16) des FET aufgeteilt ist,
bei der auf diese Schicht eine n⁺-dotierte Schicht aus InGaAs folgt, die entsprechend strukturiert ist, so daß sie in einen n⁺-Bereich (3) der Fotodiode und einen n⁺-Bereich (13) des FET aufgeteilt ist,
bei der sich auf dem n⁺-Bereich (13) des FET ein Gate (11) aus p⁺-dotiertem InGaAs befindet, das durch Seitenbereiche (18) aus n-dotiertem InP von dem Drain-Kontakt (15) und dem Source-Kontakt (17) isoliert ist und mit dem Gate-Kontakt (14) versehen ist,
bei der sich auf dem n⁺-Bereich (3) der Fotodiode eine Deckschicht (7) aus n-dotiertem InP befindet die von einem ring förmigen n-Kontakt(s) umgeben ist, und bei der ein p-Kontakt (4; 40) für die Fotodiode vorhanden ist.

2. Fotodiode-FET-Kombination nach Anspruch 1,
bei der der p⁺-dotierte Bereich (2) der Fotodiode eine nicht überwachsene Kontaktfläche (8) aufweist,
bei der der p-Kontakt (4) für die Fotodiode auf dieser Kontaktfläche (8) aufgebracht ist und
bei der dieser p-Kontakt (4) leitend mit einer Bond-Fläche des Gate-Kontaktes (14) verbunden ist.

3. Fotodiode nach Anspruch 1,
**dadurch gekennzeichnet,**
- daß eine Kontaktfläche (80) für den p-Kontakt (40) der Fotodiode durch zumindest einen Anteil der dem n⁻-Bereich (6) abgewandten Oberfläche des p⁺-Bereiches der Fotodiode (2) gegeben ist,
- daß diese Kontaktfläche (80) durch eine Aussparung des Substrates (10) freigelegt ist,
- daß die mit der Aussparung versehene Seite des Substrates (10) mit Ausnahme der Kontaktfläche (80) mit einer Isolationsschicht (9) überzogen ist und
- daß der p-Kontakt (40) auf dieser ausgesparten Seite des Substrates (10) ganzflächig aufgebracht ist.

## Claims

1. Photodiode-FET combination on a substrate (1; 10) composed of semi-insulating InP, in which a p⁺-doped region (2) of the photodiode and a p⁺-doped region (12) of the FET have been formed in said substrate (1; 10), in which a layer of n⁻-doped InGaAs has been grown on the substrate (1; 10) and is patterned in such a way that it is divided into an n⁻-type region (6) of the photodiode and an n⁻-type region (16) of the FET, in which there follows on said layer, an n⁺-doped layer of InGaAs which is appropriately patterned so that it is divided into an n⁺-type region (3) of the photodiode and an n⁺-type region (13) of the FET, in which there is, on the n⁺-type region (13) of the FET, a gate (11) of p⁺-doped InGaAs which is insulated by lateral regions (18) of n-doped InP from the drain contact (15) and the source contact (17) and which is provided with the gate contact (14), in which there is, on the n⁺-type region (3) of the photodiode, a covering layer (7) of n-doped InP which is surrounded by an annular n-type contact (5), and in which a p-type contact (4; 40) is present for the photodiode.

2. Photodiode-FET combination according to Claim 1, in which the p⁺-doped region (2) of the photodiode has a contact area (8) which has not been grown over, in which the p-type contact (4) for the photodiode has been applied to said contact area (8), and in which said p-type contact (4) is conductively connected to a bond area of the gate contact (14).

3. Photodiode according to Claim 1, characterized
- in that a contact area (80) for the p-type contact (40) of the photodiode is provided at least by one portion of that surface of the p⁺-type region of the photodiode (2) which is remote from the n⁻-type region (6),
- in that said contact area (80) is laid bare by a recess in the substrate (10),
- in that that side of the substrate (10) which is provided with the recess is coated with an insulating layer (9) with the exception of the contact area (80), and
- in that the p-type contact (40) is applied surface-wide on said recessed side of the substrate (10).

## Revendications

1. Combinaison photodiode-transistor à effet de champ (FET) sur un substrat (1; 10) en InP semi-isolant,
dans laquelle sont formées, dans ce substrat (1; 10), une zone dopée p⁺ (2) de la photodiode et une zone dopée p⁺ (12) du FET,
dans laquelle, sur le substrat (1; 10), est déposée par épitaxie une couche InGaAs dopée n⁻, qui est structurée de telle sorte qu'elle est subdivisée en une zone n⁻ (6) de la photodiode et en une zone n⁻ (16) du FET,
dans laquelle, sur cette couche, est disposée une couche dopée n⁺ en InGaAs, qui est structurée de manière correspondante, de telle sorte qu'elle est subdivisée en une zone n⁺ (3) de la photodiode et en une zone n⁺ (13) du FET,
dans laquelle se trouve, sur la zone n⁺ (13) du FET, une grille (11) en InGaAs dopé p⁺, qui est isolée, par des zones partielles (18) en InP dopé n, du contact de drain (15) et du contact de source (17), et qui est munie du contact de grille (14),
dans laquelle se trouve, sur la zone n⁺ (3) de la photodiode, une couche de couverture (7) en InP dopé n, qui est enveloppée d'un contact-n (5) en forme de cercle, et
dans laquelle est présent un contact-p (4; 40) pour la photodiode.

2. Combinaison photodiode-FET suivant la revendication 1,
dans laquelle la zone dopée p⁺ (2) de la photodiode comporte une surface de contact (8) qui n'est pas recouverte,
dans laquelle le contact p (4) pour la photodiode est déposé sur cette surface de contact (8), et
dans laquelle ce contact-p (4) est relié de manière conductrice à une surface de connexion du contact de grille (14).

3. Photodiode suivant la revendication 1,
caractérisée par le fait
- qu'une surface de contact (80) pour le contact-p (40) de la photodiode est obtenue par au moins une partie de la surface, tournée à l'opposé de la zone-n⁻ (6), de la zone-p⁺ (2) de la photodiode,
- que cette zone de contact (80) est mise à nue par une ouverture ménagée dans le substrat (10),
- que la partie du substrat (10) pourvue de l'ouverture, à l'exception de la surface de contact (80), est recouverte d'une couche isolante (9), et
- que le contact-p (14) est déposé sur toute la surface, sur la partie évidée du substrat (10).
